# FASCICULE DE BREVET EUROPEEN

(11) **EP 4 075 526 B1**
(45) Date de publication et mention de la délivrance du brevet: **04.11.2026**
(21) Numéro de dépôt: 22167688.5
(22) Date de dépôt: 11.04.2022
(51) Int. Cl.: H10N 30/30, H10N 30/50, H10N 30/88, H10N 30/01, H10N 30/02, H10N 30/072, H10N 30/074

(54) **DISPOSITIF À TRANSDUCTION PIÉZORÉSISTIVE ET SON PROCÉDÉ DE FABRICATION**
VORRICHTUNG MIT PIEZORESISTIVER TRANSDUKTION UND VERFAHREN ZU IHRER HERSTELLUNG
PIEZORESISTIVE TRANSDUCTION DEVICE AND METHOD FOR MANUFACTURING THE SAME

(30) Priorité: 14.04.2021 FR 2103867
(43) Date de publication de la demande: 19.10.2022
(73) Titulaire: Commissariat à l'Energie Atomique et aux Energies Alternatives, 75015 Paris (FR)
(72) Inventeur: CASSET, Fabrice, 38054 Grenoble Cedex 09 (FR)
(74) Mandataire: Hautier IP

(56) Documents cités:
- EP-A1- 3 213 923
- WO-A1-2022/104099
- FR-A1- 3 082 997
- JP-A- 2004 200 382
- JP-A- 2016 162 820
- US-A1- 2017 194 937

## Description

### DOMAINE TECHNIQUE

La présente invention concerne le domaine des dispositifs piézoélectriques.

De manière générale, ce type de dispositif fait appel à la capacité de transduction de matériaux piézoélectriques, ou encore éventuellement dans un domaine de fonctionnement où ils sont ferroélectriques. Cela concerne les actionneurs sous forme de dispositifs micro-électroniques. Par dispositif micro-électronique, on entend tout type de dispositif réalisé avec les moyens de la microélectronique. Ces dispositifs englobent des dispositifs micromécaniques ou électromécaniques, à l'échelle microscopique, ce qui inclut éventuellement aussi des dimensions nanométriques.

### ETAT DE LA TECHNIQUE

Des dispositifs du type capteurs ou actionneurs sont de plus en plus répandus. Les transducteurs piézoélectriques sont notamment très bien adaptés pour servir de capteurs via l'effet piézoélectrique direct ou d'actionneurs via l'effet piézoélectrique indirect. Il y a donc un intérêt pour intégrer de tels transducteurs ou des réseaux de transducteurs sur différentes surfaces, y compris des surfaces non planes ou flexibles.

Les documents JP 2004/200382 A, EP 3 213 923 A1, JP 2016/162820 A, WO2022/104099 A1, FR3082997 A1, et US 2017/194937 A1 par exemple divulguent des dispositifs comprenant des éléments piézoélectriques.

Des actionneurs piézoélectriques sont disponibles sur le marché sous forme de patchs flexibles, par exemple comme ceux vendus sous la marque DuraAct^{®} par la société PI Ceramic. De tels patchs intègrent un ou plusieurs éléments en céramique piézoélectrique coopérant par leurs deux faces avec deux électrodes, l'ensemble étant noyé dans un enrobage d'isolation électrique configuré pour préserver une certaine flexibilité. Typiquement, les actionneurs ainsi formés présentent une épaisseur supérieure à 400 micromètres ce qui reste relativement important.

Cependant, il apparaît difficile d'obtenir des épaisseurs contrôlées, potentiellement plus faibles, avec ce type de technologie. D'autre part, la flexibilité du dispositif est directement impactée par la structure de ce type de transducteurs.

Il existe donc un besoin pour proposer des dispositifs à transduction piézoélectrique qui répondent au moins en partie aux limitations techniques de l'art antérieur.

Les autres objets, caractéristiques et avantages de la présente invention apparaîtront à l'examen de la description suivante et des dessins d'accompagnement. Il est entendu que d'autres avantages peuvent être incorporés.

### RESUME

Pour atteindre cet objectif, selon un mode de réalisation, on prévoit un dispositif à transduction piézoélectrique selon la revendication indépendante de dispositif 1.

De manière avantageuse, le dispositif est tel que la face supérieure est intégralement exposée ou n'est recouverte, partiellement ou non, que du deuxième élément de connexion électrique.

On forme ainsi un dispositif dans lequel l'élément piézoélectrique n'est pas intégralement noyé dans un enrobage polymère, contrairement à ce qui est le cas dans les dispositifs actuels. De ce fait, l'élément piézoélectrique est beaucoup plus libre mécaniquement que dans les techniques actuelles de détection piézoélectrique. Cette caractéristique permet d'améliorer le comportement mécanique de l'ensemble du dispositif.

Alors qu'il est actuellement considéré que l'élément piézoélectrique est nécessairement noyé dans le reste du dispositif, on combat ici ce préjugé avec un empilement plus favorable à la flexibilité mécanique et au couplage électromécanique entre l'actionneur et la future surface qui recevra l'actionneur.

Un autre aspect concerne un procédé de fabrication d'un dispositif à transduction piézoélectrique selon la revendication indépendante de procédé 11.

Suivant un aspect, l'élément piézoélectrique est obtenu après une phase d'amincissement d'un bloc piézo-électrique, de préférence alors que ce bloc est monté sur un substrat, ce qui permet d'atteindre une épaisseur cible d'élément piézoélectrique parfaitement contrôlée, dans une large gamme de valeurs. Particulièrement, on peut obtenir des éléments piézoélectriques finaux avec une épaisseur comprise entre 10 et 100 micromètres. De préférence, l'élément piézoélectrique est monté, puis aminci, et raccordé électriquement alors que le support est porté par un substrat, par exemple en matériau semi-conducteur, peu sensible à l'élévation de température et plus rigide que le support, ce qui permet un traitement thermique d'amélioration des propriétés piézoélectrique de l'élément et facilite les opérations, par exemple d'amincissement.

De préférence, le procédé est configuré pour obtenir un dispositif à transduction piézoélectrique selon l'un quelconque des modes de réalisation ici proposés.

Le dispositif peut être intégré, seul ou avec d'autres, dans des actionneurs piézoélectriques, notamment sous forme de vignettes pouvant être rapportées sur un système plus complexe ; on peut notamment réaliser des systèmes à plaque vibrante dans lesquels au moins un dispositif est relié mécaniquement à une plaque pour l'actionner en vibration sous commande électrique du dispositif.

### BREVE DESCRIPTION DES FIGURES

Les buts, objets, ainsi que les caractéristiques et avantages de l'invention ressortiront mieux de la description détaillée d'un mode de réalisation de cette dernière qui est illustré par les dessins d'accompagnement suivants dans lesquels :
Les figures 1 à 8 représentent des étapes successives possibles pour la fabrication d'un dispositif.
La figure 9 illustre un premier exemple de dispositif.
La figure 10 montre un exemple d'application d'un système à plaque vibrante.
Les figures 11 et 12 représentent un autre exemple de réalisation.
La figure 13 montre une possibilité de formation d'une électrode sur une face d'un élément.
La figure 14 montre une autre possibilité avec deux électrodes sur une face d'un élément.
Les figures 15A à 16 représentent un autre exemple de réalisation qui ne fait pas partie de l'invention.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques.

### DESCRIPTION DÉTAILLÉE

Avant d'entamer une revue détaillée de modes de réalisation de l'invention, sont énoncées ci-après des caractéristiques optionnelles qui peuvent éventuellement être utilisées en association ou alternativement :
- le dispositif comprend un cordon 50 en matériau polymère entourant l'élément piézoélectrique 20 ;
- le cordon 50 s'étend latéralement à moins de 5000 micromètres de l'élément piézoélectrique 20 ;
- le cordon 50 présente une face supérieure coplanaire à la face supérieure 22 ;
- la deuxième zone est située sur la face supérieure 22 ;
- une couverture 60 en matériau polymère couvre partiellement le deuxième élément de connexion et au moins partiellement le cordon 50, sans couvrir la face supérieure 22 ;
- la couverture 60 s'étend latéralement au-delà du cordon ; ainsi, par exemple, la couverture 60 peut couvrir toute la surface du support 10 hormis au niveau de la face supérieure 22 de l'élément 20 est, éventuellement, au niveau de zones de reprise de contact des pistes 41,42 pour le raccordement à un circuit électrique tel qu'une source d'alimentation
- la première zone et la deuxième zone sont situées sur la face inférieure 21 ; dans ce cas, il est aussi possible de disposer d'une couverture (60) en matériau polymère, couvrant partiellement le premier élément de connexion et le deuxième élément de connexion, sans couvrir la face supérieure (22) ;
- le support 10 est souple ;
- l'élément céramique piézoélectrique 20 présente une dimension en épaisseur inférieure ou égale à 100 micromètres, et de préférence supérieure ou égale à 10 micromètres;
- le dispositif selon l'invention forme un actionneur mécanique.
- l'élément piézoélectrique 20 est au moins en partie en céramique.
- Avant l'amincissement, une formation du support 10 sur un substrat 70, et, après l'amincissement, un démontage du support 10 relativement au substrat 70 ;
- une formation du premier élément de connexion et du deuxième élément de connexion, dans laquelle le collage est configuré pour mettre en contact le premier élément de connexion et le deuxième élément de connexion avec, respectivement, la première zone et la deuxième zone, la première zone et la **deuxième** zone étant situées sur la face inférieure 21 de l'élément piézoélectrique 20 ;
- une fourniture du bloc piézoélectrique 23 qui comprend une électrode sur sa face inférieure, une division de l'électrode en une première partie et une deuxième partie qui sont électriquement isolées l'une de l'autre, la première partie et la deuxième partie formant, respectivement, la première zone et la deuxième zone.

Il est précisé que, dans le cadre de la présente invention, le terme « sur » ou « au-dessus » ne signifie pas obligatoirement « au contact de ». Ainsi, par exemple, le dépôt d'une couche sur une autre couche, ne signifie pas obligatoirement que les deux couches sont directement au contact l'une de l'autre mais cela signifie que l'une des couches recouvre au moins partiellement l'autre en étant, soit directement à son contact, soit en étant séparée d'elle par un film, ou encore une autre couche ou un autre élément. Ainsi, les termes « recouvre » et « recouvrement » peuvent aussi bien signifier « recouvre directement » et « recouvrement direct » que « recouvre indirectement » et « recouvrement indirect », respectivement.

Il est précisé que dans le cadre de la présente invention, l'épaisseur d'une couche ou du substrat se mesure selon une direction perpendiculaire à la surface selon laquelle cette couche ou ce substrat présente son extension maximale. Si une couche n'est pas totalement plane, notamment parce qu'elle présente des défauts qui sont susceptibles d'être en relief sur la face exposée de ladite couche, l'épaisseur s'entend de la dimension de cette couche en dehors de ses défauts.

Certaines parties du dispositif de l'invention peuvent avoir une fonction électrique. Certaines sont employées pour des propriétés de conduction électrique et on l'entend comme ayant une nature électriquement conductrice, des éléments formés d'au moins un matériau ayant une conductivité électrique suffisante, dans l'application, pour réaliser la fonction souhaitée.

On entend par un substrat, un élément, une couche ou autre « à base » d'un matériau M, un substrat, un élément, une couche comprenant ce matériau M uniquement ou ce matériau M et éventuellement d'autres matériaux, par exemple des éléments d'alliage, des impuretés ou des éléments dopants. Le cas échéant, le matériau M peut présenter différentes stoechiométries.

On entend par « souple », en particulier pour qualifier le support, que le support a une flexibilité importante, ce qui inclut notamment des supports remplissant au moins l'une des conditions suivantes :
- le support, qui peut porter un actionneur piézoélectrique ou ferroélectrique, est à base d'un ou plusieurs matériaux polymères, ces derniers pouvant être choisis parmi le polyester, le polyimide, le polytétrafluoroéthylène, le polyétheréthercétone.
- le support a une capacité de déformation en flexion avec un rayon de courbure de moins d'un mètre, et de préférence de moins de 200 mm, sans rupture ;
- le matériau du support présente un module de Young inférieur ou égal à 5000 MPa, et de préférence inférieure ou égale à 3500 MPa ; cependant, le support peut comporter au moins une couche en matériau moins élastique, tel que du verre, et, dans ce cas, avec des épaisseurs maximales plus faibles pour préserver la flexibilité.

Avant de présenter des modes de fabrication d'un dispositif 1 à transduction piézoélectrique, différents exemples de structures pouvant être obtenues sont ci-après décrits.

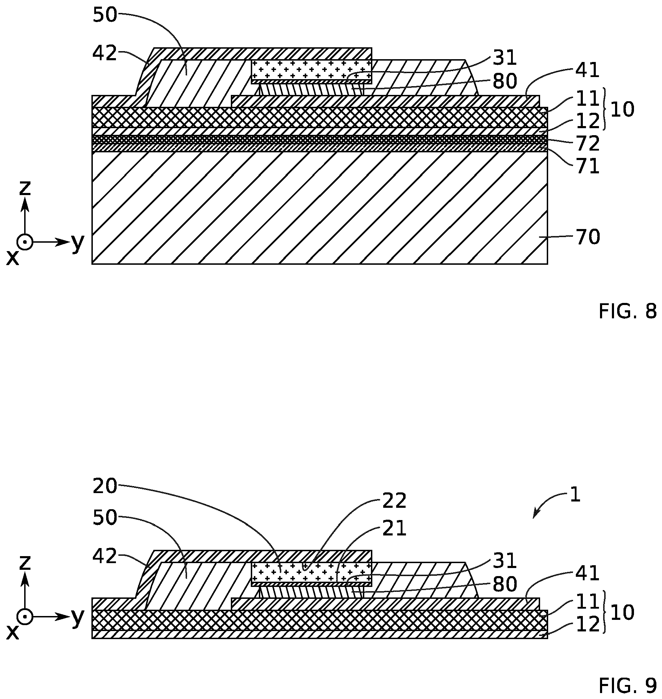

Ainsi, la figure 9 montre, en section, un exemple d'empilement formant un dispositif 1 à transduction piézoélectrique. Un support 10 est illustré, et il est de préférence réalisé de manière souple. Par exemple, il comporte une couche supérieure 11 qui va recevoir un empilement de transduction piézoélectrique ; selon un exemple, la couche supérieure est faite de ou à base de polymère SINR ; son épaisseur peut être inférieure à 100 micromètres, et par exemple de 80 micromètres. Une couche inférieure 12 est aussi représentée, dont on verra que son interface avec une couche sous-jacente peut servir à la fabrication. Par exemple, la couche 12 peut être réalisée en, ou à base de, TEOS (orthosilicate de tétraéthyle); son épaisseur est avantageusement inférieure à celle de la couche supérieure 11; l'épaisseur peut être par exemple être inférieure à 1 micromètre, et de préférence de 500 nm.

Par exemple, l'épaisseur globale du support 10 peut être inférieure à 200 micromètres, et de préférence inférieure à 100 micromètres.

La face supérieure du support 10 sert de support à un empilement de transducteurs. Ce dernier comprend successivement, dans ce premier exemple, un premier élément de connexion électrique, un élément piézoélectrique (ce qui est ici défini comme un élément fait dans un matériau ayant des propriétés piézoélectriques, ce qui inclut des matériaux piézoélectriques pouvant fonctionner, en particulier sous certaines conditions de sollicitation électrique, de sorte à disposer d'un effet ferroélectrique ; ainsi, des matériaux ferroélectriques sont aussi visés pour réaliser l'élément piézoélectrique) et un deuxième élément de connexion électrique.

Le premier élément de connexion électrique a vocation à produire un raccordement électrique d'une première zone de l'élément piézoélectrique. En combinaison avec le deuxième élément de connexion électrique raccordant une deuxième zone de l'élément piézoélectrique, on pourra ainsi, soit appliquer un courant électrique de commande à l'élément piézoélectrique, soit récupérer un courant généré par l'élément piézoélectrique. La première zone et la deuxième zone de l'élément piézoélectrique sont des éléments de la surface externe de l'élément piézoélectrique.

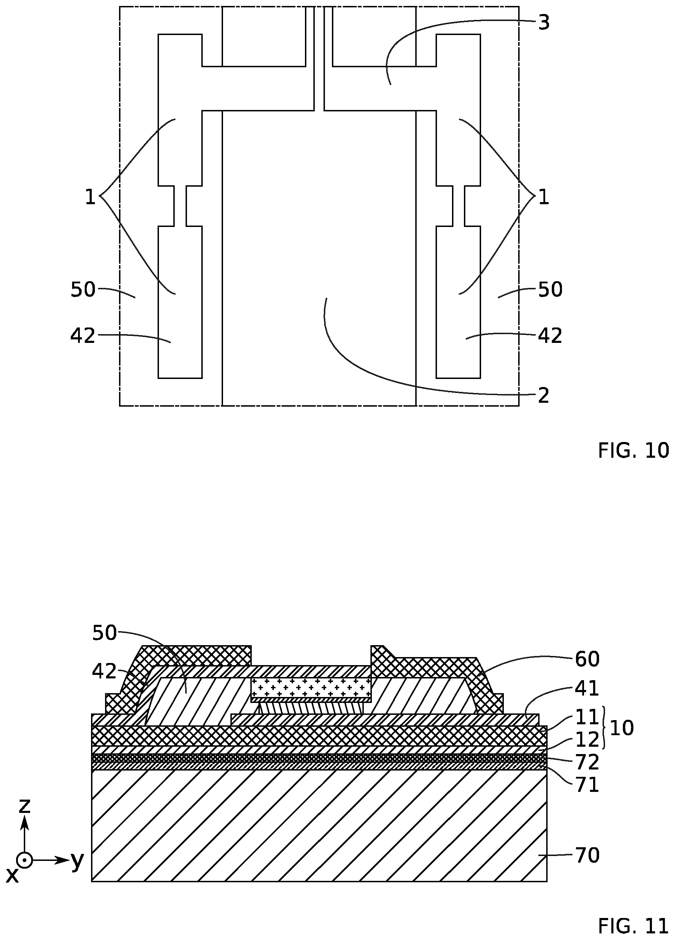

Le premier élément de connexion électrique est au moins en partie réalisé par une première piste 41 en matériau électriquement conducteur, et qui peut s'étendre sur le support 10 suivant un motif adapté au raccordement électrique de l'élément piézoélectrique 20. Dans cet exemple de réalisation, la première piste 41 s'étend au moins partiellement sous l'élément piézoélectrique 20, et de préférence, elle s'étend aussi latéralement pour réaliser un raccordement déporté à une ligne de connexion électrique 3, visible la figure 10. On peut employer des matériaux électriquement conducteurs comme du tungstène ou de l'or pour former, en une ou plusieurs couches, la piste 41.

Le premier élément de connexion électrique peut aussi comprendre au moins une partie d'une couche de collage 80 permettant la fixation de l'élément piézoélectrique sur le support 10. Dans ce contexte, la couche 80 est une colle conductrice, par exemple de la pâte d'argent.

L'élément piézoélectrique 20 peut être réalisé en céramique piézoélectrique, en PZT notamment. Dans l'exemple représenté, il a une forme parallélépipédique rectangle, indicative. Sa dimension en épaisseur peut être plus limitée que dans les patchs habituels, et elle peut notamment être inférieure ou égale à 100 micromètres. Dans le même temps, ou alternativement, la dimension en épaisseur peut être supérieure ou égale à 10 microns.

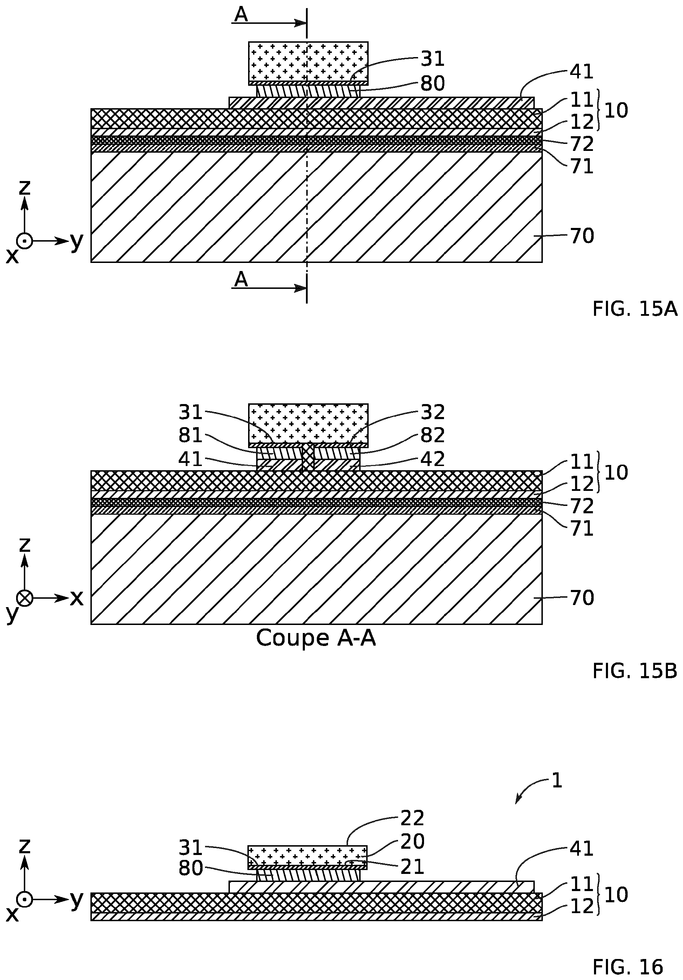

L'élément piézoélectrique 20 comporte une face, dite face inférieure 21, dirigée en regard du support 10 ; à l'opposé, une face supérieure 22 est dirigée vers l'extérieur du dispositif. Les références 21 et 22 apparaissent notamment aussi dans l'exemple de réalisation fourni à la figure 16, qui ne fait pas partie de l'invention.

De préférence, au moins l'une des faces inférieure et supérieure s'étend parallèlement à la face supérieure du support 10. De préférence, l'extension latérale de l'élément piézoélectrique 20 est inférieure à l'extension latérale du support 10.

La localisation des première et deuxième zones de l'élément piézoélectrique 20 au niveau desquelles sont réalisées les connexions électriques peut notamment être choisie en fonction des applications visées pour le dispositif. Elles peuvent notamment se trouver toutes les deux au niveau d'une même face de l'élément piézoélectrique parmi sa face inférieure 21 et sa face supérieure 22. Elles peuvent également se trouver chacune sur l'une de ces deux faces opposées 21, 22.

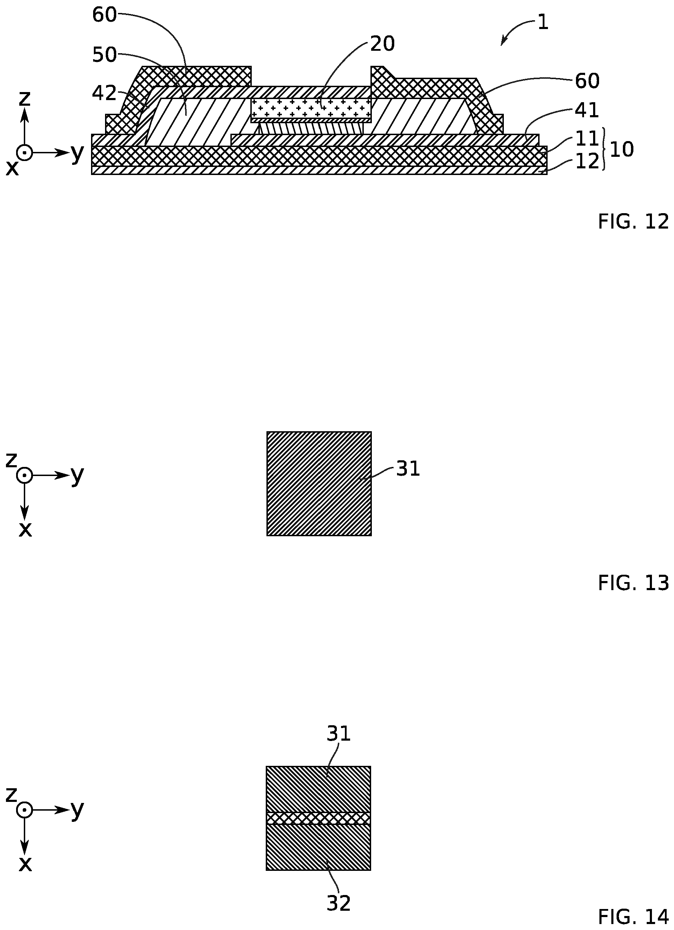

Selon l'illustration, le matériau piézoélectrique proprement dit est au contact d'une couche électriquement conductrice sous-jacente, réalisant l'interface entre l'élément piézoélectrique 20 et le premier élément de connexion électrique, agissant sous forme d'électrode. Il peut s'agir d'une couche métallique. La figure 13 donne un exemple de première électrode 31 produisant la face inférieure 21 de l'élément 20.

La figure 9 montre enfin un exemple de réalisation du deuxième élément de connexion électrique, avec une deuxième piste 42, pouvant être formée dans des matériaux similaires que ceux évoqués pour la piste 41, et s'étendant sur au moins une partie de la face supérieure 22 de l'élément piézoélectrique 20 pour en assurer le raccordement électrique. Comme pour la piste 41, la piste 42 s'étend, selon cet exemple, latéralement au-delà de l'élément 20 pour permettre une connexion électrique avantageusement déportée.

L'empilement ainsi proposé comporte, dans l'invention, un cordon 50 réalisé dans un matériau électriquement isolant. Il pourra s'agir d'un matériau polymère, par exemple une résine époxy. Il est configuré pour s'appliquer latéralement sur l'élément piézoélectrique 20, de sorte à l'entourer, sur au moins une partie du contour de l'élément 20. De préférence, le cordon 50 s'applique sur au moins deux bords opposés du contour de l'élément 20, et de préférence sur les quatre côtés de l'élément 20. De préférence, le cordon 50 entoure complètement l'élément 20.

Le cordon 50 permet de maintenir et de protéger l'élément piézoélectrique 20, et de renforcer mécaniquement l'ensemble. De plus, il isole avantageusement la première piste 41 et la deuxième piste 42, ou, plus généralement, le premier élément de connexion électrique et le deuxième élément de connexion électrique. À cet effet, au moins une partie du deuxième élément de connexion électrique, telle que la piste 42 représentée à la figure 9, est disposée sur le cordon 50 ; dans le même temps ou alternativement, le cordon 50 recouvre au moins une partie du premier élément de connexion électrique, telle que la portion de la piste 41 s'étendant sous et à proximité de l'élément piézoélectrique 20.

De préférence, le cordon 50 présente une face supérieure plane. Avantageusement, c'est aussi le cas de l'élément piézoélectrique 20. De plus, ces faces supérieures peuvent être coplanaires. Dans ce contexte, seule la piste 42 s'étend au-dessus de cet ensemble, si bien que le maintien, en particulier latéral, de l'élément piézoélectrique 20 est produit par le cordon 50, sans pour autant générer une hauteur trop importante de ce cordon, pour préserver la flexibilité du dispositif. En outre, le cordon 50 ne s'étend pas, de préférence, sur toute la surface du support 10.

La figure 12 reflète une variante de réalisation proche du cas de la figure 9, notamment en ce que le support, le premier élément de connexion électrique, l'élément piézoélectrique et le deuxième élément de connexion électrique peuvent être réalisés de la même manière. Au surplus, dans ce mode de réalisation, une couche de couverture 60 s'étend au-dessus de cordon 50, et, lorsque cet élément est présent, au-dessus du deuxième élément de connexion électrique, par exemple la deuxième piste 42. Un intérêt de cette couche de couverture 60 et de protéger les pistes électriques. Le matériau de cette couche est de préférence un isolant électrique.

Cette couche 60 présente également un intérêt mécanique en plaçant les pistes électriques à la fibre neutre, de sorte à les fiabiliser.

La couche 60 sera typiquement en matériau polymère, tel que du SINR, du PEN, du PET, du PC.

Cependant, la couche 60 ne s'étend pas au-dessus de l'élément piézoélectrique 20 qui est ouvert en totalité (hormis éventuellement la présence de la deuxième piste 42), ce qui permet de ne pas réduire les performances comme ce serait le cas si la couche 60 était disposée au-dessus avec l'effet inévitable d'amortissement des déformations de l'élément piézoélectrique.

De préférence, la couche de couverture 60 est conforme ; elle peut être obtenue par laminage. Dans l'exemple représenté à la figure 12, la couche 60 recouvre la face supérieure du cordon 50 et sa tranche, qui est de préférence inclinée. La couche de protection 60 ne s'étend pas forcément sur le support 10 ; à la figure 12, le contact entre le support 10 est la couche 60 s'effectue sur une largeur inférieure ou égale à l'épaisseur de la couche de couverture 60.

Dans un autre mode de réalisation représentée la figure 16, qui ne fait pas partie de l'invention, le cordon 50 n'est pas présent, ni même la couche de couverture 60. Dans cette option, le raccordement électrique de l'élément piézo-électrique 20 s'effectue par le dessous. Bien entendu, cette disposition de raccordement électrique est compatible avec la présence du cordon 50 seul ou en combinaison avec la couche de couverture 60.

Alors que dans les exemples précédents le deuxième élément de connexion électrique coopérait avec une zone de la face supérieure 22 de l'élément piézoélectrique 20, la configuration de la figure 16 propose que cette zone soit située sur une portion de la face inférieure 21 de l'élément piézoélectrique 20. Dans ce contexte, on peut mettre en œuvre une division, avec isolation intermédiaire, de la face inférieure 21 de l'élément piézoélectrique 20. Comme le montre la figure 14, en contrepoint de la figure 13, la face inférieure 21 comprend une première électrode 31 et une deuxième électrode 32 électriquement isolées l'une de l'autre par une bande d'un matériau diélectrique, qui peut être de l'air. Chacune des électrodes 31,32 forme une continuité électrique avec, respectivement, les composants du premier élément de connexion électrique et les composants du deuxième élément de connexion électrique.

Dans ce contexte, si l'élément piézoélectrique 20 est monté sur le support 10 par l'intermédiaire d'une couche de collage 80, cette dernière est également divisée en deux portions isolées électriquement l'une de l'autre 81,82. Cette configuration est représentée dans l'étape de fabrication correspondant à la figure 15B. Ainsi, la connexion électrique s'opère, pour le premier élément de connexion électrique, par la première piste 41, une première portion 81 de la couche de collage 80 et la première électrode 31. Parallèlement, pour le deuxième élément de connexion électrique, cette connexion s'opère par la deuxième piste 42, une deuxième portion 82 de la couche de collage 80 et la deuxième électrode 32.

À noter que la présence des électrodes 31,32, quel que soit le mode de réalisation, n'est pas indispensable. Notamment, les pistes 41, 42 peuvent s'appliquer directement sur l'élément piézoélectrique 20, ou par l'intermédiaire d'autres organes, comme les couches de collage 81 et 82.

La configuration de la figure 16 présente l'avantage de ne pas nécessiter un raccordement électrique de la face supérieure 22 de l'élément 20, ce raccordement impliquant une isolation verticale comme dans le cas des figures 9 et 12.

Le dispositif 1, tel que présenté dans les trois variantes précédentes, peut être réalisé par un procédé de fabrication dont un exemple est fourni maintenant.

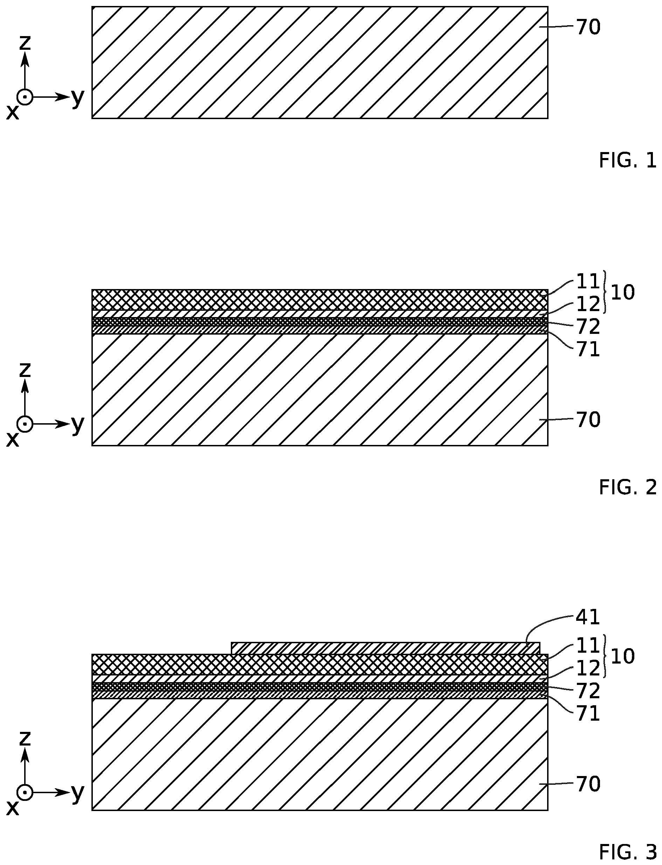

À la figure 1, est représentée la possibilité de disposer d'un substrat 70 apte à servir de support, de préférence plus rigide que le support 10, lors de certaines étapes de fabrication. Par exemple, le substrat 70 peut être constitué, ou comprendre, une couche d'un matériau semi-conducteur, comme du silicium.

La figure 2 montre que le support 10 peut être fabriqué par des dépôts de couches sur une face du substrat 70. La formation d'un support 10, par exemple avec une couche supérieure 11 et une couche supérieure 12 peut correspondre aux exemples précédemment donnés, en termes de choix de matériaux. De préférence, une partie intermédiaire 71,72 est d'abord déposée pour servir de portion de désolidarisation ultérieure entre le substrat 70 et le support 10. Par exemple, cette portion intermédiaire peut comprendre une couche d'interface 72 prise en sandwich entre une couche intermédiaire 71 et la couche inférieure 12 du support 10. La couche 71 peut être faite du même matériau que la couche 12 et/ou présenter la même épaisseur. La couche d'interface 72 peut par exemple être une bicouche comprenant une première sous-couche en titane (par exemple de 10 nm) et une deuxième sous-couche, superposée à la première, en platine (par exemple de 100 nm). On verra que cette disposition permet de créer une interface de plus faible force d'adhérence que les autres, pour favoriser la désolidarisation du support 10 relativement au substrat 70 lors d'une phase ultérieure.

La figure 3 présente un exemple de réalisation d'une première piste 41, par exemple en une ou plusieurs couches métalliques. On pourra utiliser des techniques de dépôt et de définition de motifs traditionnelles.

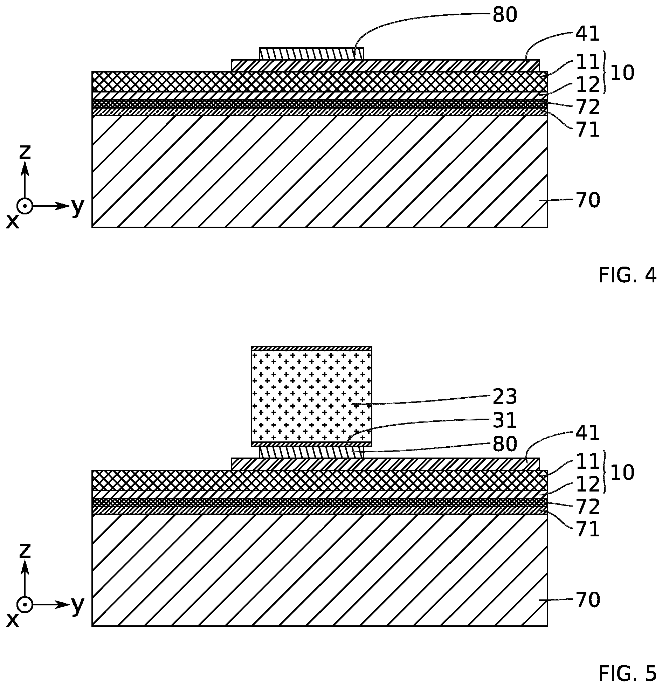

À la figure 4, une colle conductrice est déposée, par exemple par sérigraphie, pour former la couche de collage 80 ; elle est en continuité électrique avec la piste 41.

Un bloc piézoélectrique 23 est reçu par la couche de collage 80. La face inférieure de ce bloc 23 forme la face inférieure de l'élément piézoélectrique 20 à former. On pourra utiliser à titre de bloc 23 un composant piézoélectrique du marché. De ce fait, il peut comprendre, par fabrication, une électrode inférieure (pouvant former au moins la première électrode 31, voire la deuxième électrode 32 lorsqu'elle est située sur la face inférieure 21) et une électrode supérieure, comme cela apparaît avec les deux fines couches entourant la portion principale du bloc 23 à la figure 5.

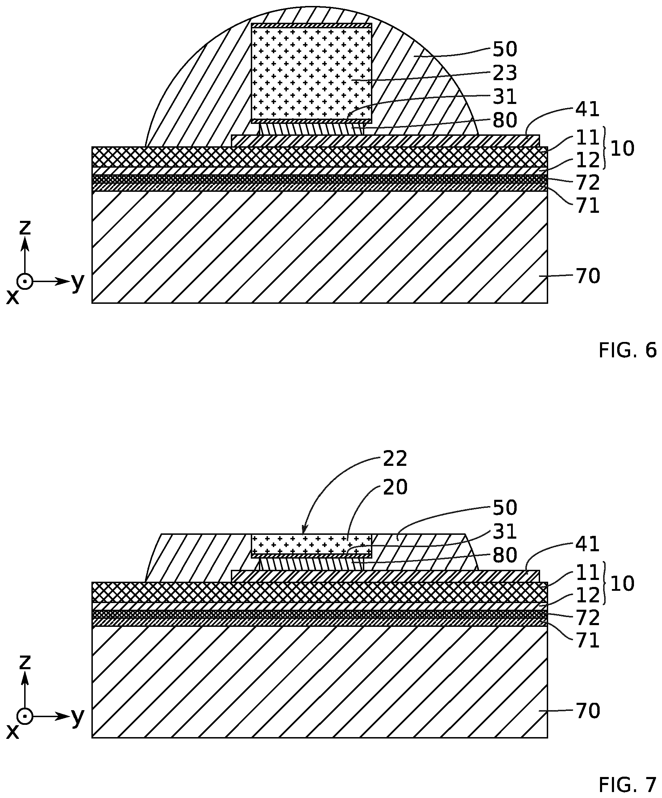

À l'étape correspondant à la figure 6, le bloc 23 a été enrobé dans une couche de matériau polymère, par exemple par dispense à la seringue de façon manuelle ou automatique, avec un recuit de polymérisation. C'est la portion basale de cette couche qui va former le cordon 50.

On opère ensuite un amincissement depuis le dessus du bloc 23, de sorte à amener l'épaisseur de matériau piézoélectrique à une valeur prédéterminée, permettant de contrôler l'épaisseur de l'élément piézoélectrique 20 à former. Cet amincissement peut s'opérer par meulage et/ou polissage mécanique et/ou mécanochimique Le résultat produit est l'élément piézoélectrique 20 visible la figure 7 et obtenue à partir du bloc piézoélectrique 23 plus épais. Un avantage d'un tel amincissement est d'obtenir une face supérieure de l'ensemble du dispositif plane et parallèle au support, le cordon 50 affleurant au niveau de la face supérieure 22 de l'élément piézoélectrique 20. À ce stade, ce dernier a été mis en forme et son épaisseur est contrôlée.

Éventuellement, le cordon 50 peut être fabriqué après la réduction d'épaisseur du bloc 23. Par ailleurs, comme vu précédemment, la formation du cordon 50 est optionnelle et, dans ce cas, l'amincissement est dédié au bloc 23 seul. Recourir à cet amincissement pourrait paraître comme un inconvénient induisant une étape de fabrication et une perte du matériau piézoélectrique ; cependant, il permet de contrôler l'épaisseur de l'élément piézoélectrique 20 tout en évitant des manipulations de l'élément piézoélectrique 20 qui pourraient empêcher d'atteindre de faibles épaisseurs.

La figure 8 montre la création d'une deuxième piste 42, par exemple de manière similaire à la formation de la piste 41, mais au-dessus du cordon 50 cette fois.

De préférence, le substrat 70 est préservé jusqu'à la fin de ces étapes. Lorsque le dispositif est terminé, ou pour le moins que certaines phases de fabrication ont été opérées, le support 10 est désolidarisé du substrat 70. Le résultat final correspond à celui de la figure 9, dans le premier exemple de configuration du dispositif.

Le retrait du substrat 70 est avantageusement réalisé grâce à la couche d'interface 72. Cette dernière est une couche sacrificielle gravée de manière sélective à son environnement, pour détacher le support 10. Pour éliminer le substrat 70 sont bien entendu possibles : clivage au niveau d'une couche ayant fait l'objet d'une implantation ionique, amincissement par la face arrière du substrat 70 par exemple. On peut aussi choisir la couche 72 de sorte qu'elle dispose, au niveau de son interface, soit avec la couche sous-jacente, soit avec la couche qui la surmonte immédiatement, d'une force d'adhérence plus faible qu'au niveau de l'autre interface. Ainsi, lorsqu'une force de séparation mécanique, typiquement par pelage, est appliquée au support, l'interface de moindre force d'adhérence sera le lieu de la séparation.

Dans le cas de la variante présentée à la figure 11, avec la présence d'une couche de couverture 60, cette dernière peut être formée à l'issue de l'état de la figure 8, de préférence avant la séparation du substrat 70. La couche 70 peut être obtenue par laminage d'un matériau polymère, tout en préservant une ouverture au droit de l'intégralité de la face supérieure 22 de l'élément piézoélectrique 20.

Dans le cas de la variante finale représentée à la figure 16, qui n'est fait pas parti de l'invention, la fabrication peut être opérée comme précédemment, en omettant la fabrication du cordon 50 et de la couche de couverture 60. Dans cet exemple de réalisation, et plus généralement à chaque fois que les deux éléments de connexion électrique sont raccordés à la face inférieure 21 de l'élément piézoélectrique 20, et lorsque le bloc 23 est équipé d'une électrode inférieure, on aura recours à une division en deux parties de cette électrode, de sorte à former la première électrode 31 et la deuxième électrode 32 dont un exemple est visible en figure 14. Un usinage, un sciage par exemple, permet d'atteindre un tel résultat, avant le montage du bloc 23 sur la couche de collage 80.

La figure 10 reflète un système pour la mise en œuvre d'un ou plusieurs dispositifs 1 tels que décrits précédemment.

Il s'agit dans le cas d'espèce d'un système à plaque vibrante, comportant une plaque 2, par exemple en verre, de forme rectangulaire voire carrée, dont deux côtés opposés sont reliés mécaniquement à un ou plusieurs dispositifs 1. À la figure 10, sur deux bords opposés, deux dispositifs sont reliés en parallèle, avantageusement de manière symétrique relativement à un axe de symétrie de la plaque. Une ligne de connexion électrique 3 permet d'alimenter les dispositifs 1, de préférence reliés en parallèle de part et d'autre de la plaque, pour les commander. On peut notamment appliquer un mode vibratoire du type mode de Lamb à la plaque de cette manière. Un fonctionnement inverse, en capteur, est aussi possible sur la base de tels dispositifs 1.

## Revendications

1. Dispositif (1) à transduction piézoélectrique comprenant un support (10), un élément piézoélectrique (20), un premier élément de connexion (41) et un deuxième élément de connexion électrique (42), l'élément piézoélectrique (20) étant porté par le support (10) et chacun des premier et deuxième éléments de connexion électrique étant électriquement connectés, respectivement, à une première zone et une deuxième zone, distincte de la première zone, de l'élément piézoélectrique (20), l'élément piézoélectrique (20) comportant une face inférieure (21) en regard du support (10) et une face supérieure (22), opposée à la face inférieure (21), **caractérisé en ce que** la face supérieure (22) est intégralement exposée ou est intégralement recouverte par le deuxième élément de connexion électrique (42), sans autre recouvrement direct ou indirect de la face supérieure (22), le dispositif comprenant un cordon (50) en matériau polymère entourant l'élément piézoélectrique (20), au moins une partie du deuxième élément de connexion électrique (42) étant disposée sur le cordon (50) et le cordon (50) recouvrant au moins une partie du premier élément de connexion électrique (41), de sorte que le cordon (50) isole le premier élément de connexion électrique (41) et le deuxième élément de connexion électrique (42).

2. Dispositif selon la revendication précédente dans lequel le cordon (50) s'étend latéralement à moins de 5000 micromètres de l'élément piézoélectrique (20).

3. Dispositif selon l'une des deux revendications précédentes, dans lequel le cordon (50) présente une face supérieure coplanaire à la face supérieure (22).

4. Dispositif selon l'une des trois revendications précédentes, dans lequel la deuxième zone est située sur la face supérieure (22).

5. Dispositif selon la revendication précédente, comprenant une couverture (60) en matériau polymère couvrant partiellement le deuxième élément de connexion et au moins partiellement le cordon (50), sans couvrir la face supérieure (22).

6. Dispositif selon l'une quelconque des revendications 1 à 3, dans lequel la première zone et la deuxième zone sont situées sur la face inférieure (21).

7. Dispositif selon la revendication précédente, comprenant une couverture (60) en matériau polymère couvrant partiellement le premier élément de connexion électrique (41) et le deuxième élément de connexion électrique (42), sans couvrir la face supérieure (22).

8. Dispositif selon l'une quelconque des revendications précédentes, dans lequel le support (10) est souple.

9. Dispositif selon l'une quelconque des revendications précédentes, dans lequel l'élément piézoélectrique (20) présente une dimension en épaisseur inférieure ou égale à 100 micromètres, et de préférence supérieure ou égale à 10 micromètres.

10. Dispositif selon l'une quelconque des revendications précédentes formant un actionneur mécanique.

11. Procédé de fabrication d'un dispositif à transduction piézoélectrique comprenant un support (10), un élément piézoélectrique (20), un premier élément de connexion électrique (41) et un deuxième élément de connexion électrique (42), l'élément piézoélectrique (20) étant porté par le support (10) et chacun des premier et deuxième éléments de connexion électrique étant électriquement connectés, respectivement, à une première zone et une deuxième zone, distincte de la première zone, de l'élément piézoélectrique (20), l'élément piézoélectrique (20) comportant une face inférieure (21) en regard du support (10) et une face supérieure (22), opposée à la face inférieure (21), **caractérisé en ce qu'**il comprend :
• un collage d'un bloc piézoélectrique (23) sur le support (10) de sorte à placer la face inférieure du bloc piézoélectrique (23) en regard du support (10) ;
• après le collage et avant l'amincissement, un enrobage du bloc piézoélectrique (23) d'une couche de matériau polymère, et
• un amincissement du bloc piézoélectrique (23) depuis sa face supérieure (22) opposée à sa face inférieure (21), de sorte à obtenir l'élément piézoélectrique (20) avec une dimension en épaisseur prédéfinie, la face supérieure (22) de l'élément piézoélectrique (20) étant laissée intégralement exposée ou n'étant laissée recouverte que par le deuxième élément de connexion électrique (42), le deuxième élément de connexion électrique (42) recouvrant intégralement la face supérieure (22) de l'élément piézoélectrique (20),
• un amincissement de la couche de matériau polymère concomitant à l'amincissement du bloc piézoélectrique (23) de sorte à obtenir un cordon (50) entourant l'élément piézoélectrique (20) et affleurant au niveau de la face supérieure (22) de l'élément piézoélectrique (20), au moins une partie du deuxième élément de connexion électrique (42) étant disposée sur le cordon (50) et le cordon (50) recouvrant au moins une partie du premier élément de connexion électrique (41), de sorte que le cordon (50) isole le premier élément de connexion électrique (41) et le deuxième élément de connexion électrique (42).

12. Procédé selon la revendication précédente, comprenant, avant l'amincissement, une formation du support (10) sur un substrat (70), et, après l'amincissement, un démontage du support (10) relativement au substrat (70).

13. Procédé selon la revendication précédente, dans lequel le collage est configuré pour mettre en contact le premier élément de connexion électrique (41) et le deuxième élément de connexion électrique (42) avec, respectivement, la première zone et la deuxième zone, la première zone et la deuxième zone étant situées sur la face inférieure (21) de l'élément piézoélectrique (20).

14. Procédé selon la revendication précédente, comprenant une fourniture du bloc piézoélectrique (23) qui comprend une électrode (31) sur sa face inférieure (21), une division de l'électrode en une première partie et une deuxième partie qui sont électriquement isolées l'une de l'autre, la première partie et la deuxième partie formant, respectivement, la première zone et la deuxième zone.

## Patentansprüche

1. Vorrichtung (1) mit piezoresistiver Transduktion, die einen Träger (10), ein piezoresistives Element (20), ein erstes elektrisches Verbindungselement (41) und ein zweites elektrisches Verbindungselement (42) umfasst, wobei das piezoresistive Element (20) von dem Träger (10) getragen wird und jedes des ersten und des zweiten elektrischen Verbindungselements jeweils elektrisch mit einem ersten Bereich und einem zweiten Bereich, der sich von dem ersten Bereich unterscheidet, des piezoresistiven Elements (20) verbunden ist, wobei das piezoresistive Element (20) eine Unterseite (21) umfasst, die dem Träger (10) zugewandt ist, und eine Oberseite (22), die der Unterseite (21) entgegengesetzt ist, **dadurch gekennzeichnet, dass** die Oberseite (22) vollständig frei liegt oder vollständig durch das zweite elektrische Verbindungselement (42) bedeckt ist, ohne eine weitere direkte oder indirekte Bedeckung der Oberseite (22), wobei die Vorrichtung einen Strang (50) aus Polymermaterial umfasst, der das piezoresistive Element (20) umgibt, wobei mindestens ein Teil des zweiten elektrischen Verbindungselements (42) auf dem Strang (50) angeordnet ist und der Strang (50) mindestens einen Teil des ersten elektrischen Verbindungselements (41) derart bedeckt, dass der Strang (50) das erste elektrische Verbindungselement (41) und das zweite elektrische Verbindungselement (42) elektrisch isoliert.

2. Vorrichtung nach dem vorstehenden Anspruch, wobei sich der Strang (50) seitlich in mindestens 5000 Mikrometer von dem piezoresistiven Element (20) erstreckt.

3. Vorrichtung nach einem der beiden vorstehenden Ansprüche, wobei der Strang (50) eine Oberseite aufweist, die zu der Oberseite (22) koplanar verläuft.

4. Vorrichtung nach einem der drei vorstehenden Ansprüche, wobei sich der zweite Bereich auf der Oberseite (22) befindet.

5. Vorrichtung nach dem vorstehenden Anspruch, die eine Bedeckung (60) aus Polymermaterial umfasst, die das zweite Verbindungselement teilweise und den Strang (50) mindestens teilweise bedeckt, ohne die Oberseite (22) zu bedecken.

6. Vorrichtung nach einem der Ansprüche 1 bis 3, wobei der erste Bereich und der zweite Bereich auf der Unterseite (21) liegen.

7. Vorrichtung nach dem vorstehenden Anspruch, die eine Bedeckung (60) aus Polymermaterial umfasst, die das erste elektrische Verbindungselement (41) und das zweite elektrische Verbindungselement (42) teilweise bedeckt, ohne die Oberseite (22) zu bedecken.

8. Vorrichtung nach einem der vorstehenden Ansprüche, wobei der Träger (10) biegsam ist.

9. Vorrichtung nach einem der vorstehenden Ansprüche, wobei das piezoresistive Element (20) ein Dickenmaß aufweist, das kleiner oder gleich 100 Mikrometer und bevorzugt größer oder gleich 10 Mikrometer ist.

10. Vorrichtung nach einem der vorstehenden Ansprüche, die einen mechanischen Aktor bildet.

11. Verfahren zur Herstellung einer Vorrichtung mit piezoresistiver Transduktion, die einen Träger (10), ein piezoresistives Element (20) ein erstes Verbindungselement (41) und ein zweites elektrisches Verbindungselement (42) umfasst, wobei das piezoresistive Element (20) von dem Träger (10) getragen wird und jedes des ersten und des zweiten elektrischen Verbindungselements elektrisch jeweils mit einem ersten Bereich und einem zweiten Bereich, der sich von dem ersten Bereich unterscheidet, des piezoresistive Elements (20) getragen wird, wobei das piezoresistive Element (20) eine Unterseite (21) gegenüber dem Träger (10) und eine Oberseite (22), die der Unterseite (21) entgegengesetzt ist, umfasst, **dadurch gekennzeichnet, dass** es Folgendes umfasst:
• ein Kleben eines piezoresistiven Blocks (23) auf den Träger (10) derart, dass die Unterseite des piezoresistiven Blocks (23) gegenüber dem Träger (10) platziert wird;
• nach dem Kleben und vor dem Ausdünnen, ein Umhüllen des piezoresistiven Blocks (23) mit einer Schicht aus Polymermaterial, und
• ein Ausdünnen des piezoresistiven Blocks (23) ausgehend von seiner Oberseite (22), die seiner Unterseite (21) entgegengesetzt ist, derart, dass ein piezoresistives Element (20) mit einem vordefinierten Dickenmaß erhalten wird, wobei die Oberseite (22) des piezoresistiven Elements (20) integral freigelegt belassen wird oder nur durch das zweite Verbindungselement (42) bedeckt belassen wird, wobei das zweite Verbindungselement (42) die Oberseite (22) des piezoresistiven Elements (20) vollständig bedeckt,
• ein Ausdünnen der Schicht aus Polymermaterial begleitend zum Ausdünnen des piezoresistiven Blocks (23) derart, dass ein Strang (50) erhalten wird, der das piezoresistive Element (20) umgibt und im Bereich der Oberseite (22) des piezoresistiven Elements (20) mit mindestens einem Teil des zweiten elektrischen Verbindungselements (42) auf dem Strang (50) freigelegt ist, und der Strang (50) mindestens einen Teil des ersten elektrischen Verbindungselements (41) derart bedeckt, dass der Strang (50) das erste elektrische Verbindungselement (41 und das zweite elektrische Verbindungselement (42) isoliert.

12. Verfahren nach dem vorstehenden Anspruch, das vor dem Ausdünnen ein Bilden des Trägers (10) auf einem Substrat (70) umfasst und nach dem Ausdünnen eine Demontage des Trägers (10) in Bezug auf das Substrat (70).

13. Verfahren nach dem vorstehenden Anspruch, wobei das Kleben dazu konfiguriert ist, das erste elektrische Verbindungselement (41) und das zweite elektrische Verbindungselement (42) jeweils mit dem ersten Bereich und dem zweiten Bereich in Kontakt zu bringen, wobei der erste Bereich und der zweite Bereich auf der Unterseite (21) des piezoresistiven Elements (20) liegen.

14. Verfahren nach dem vorstehenden Anspruch, das eine Bereitstellung des piezoresistiven Blocks (23) umfasst, der eine Elektrode (31) auf seiner Unterseite (21), eine Teilung der Elektrode in einen ersten Teil und einen zweiten Teil, die elektrisch voneinander isoliert sind, umfasst, wobei der erste Teil und der zweite Teil jeweils den ersten Bereich und den zweiten Bereich bilden.

## Claims

1. Piezoelectric transduction device (1) comprising a support (10), a piezoelectric element (20), a first connecting element (41) and a second electrical connecting element (42), the piezoelectric element (20) being carried by the support (10) and each of the first and second electrical connecting elements being electrically connected, respectively, to a first zone and a second zone, distinct from the first zone, of the piezoelectric element (20), the piezoelectric element (20) comprising a lower face (21) facing the support (10), and an upper face (22), opposite the lower face (21), **characterised in that** the upper face (22) is fully exposed or is fully covered by the second electrical connecting element (42), without other direct or indirect covering of the upper face (22), the device comprising a polymer material cord (50) surrounding the piezoelectric element (20), at least one part of the second electrical connecting element (42) being disposed on the cord (50), and the cord (50) covering at least one part of the first electrical connecting element (41), such that the cord (50) isolates the first electrical connecting element (41) and the second electrical connecting element (42).

2. Device according to the preceding claim, wherein the cord (50) extends laterally at least 5000 micrometres from the piezoelectric element (20).

3. Device according to any one of the two preceding claims, wherein the cord (50) has an upper face coplanar to the upper face (22).

4. Device according to any one of the three preceding claims, wherein the second zone is located on the upper face (22).

5. Device according to the preceding claim, comprising a polymer material cover (60) partially covering the second connecting element and at least partially the cord (50), without covering the upper face (22).

6. Device according to any one of claims 1 to 3, wherein the first zone and the second zone are located on the lower face (21).

7. Device according to the preceding claim, comprising a polymer material cover (60) partially covering the first electrical connecting element (41) and the second electrical connecting element (42), without covering the upper face (22).

8. Device according to any one of the preceding claims, wherein the support (10) is flexible.

9. Device according to any one of the preceding claims, wherein the piezoelectric element (20) has a dimension with thickness less than or equal to 100 micrometres, and preferably greater than or equal to 10 micrometres.

10. Device according to any one of the preceding claims, forming a mechanical actuator.

11. Method for manufacturing a piezoelectric transduction device comprising a support (10), a piezoelectric element (20), a first electrical connecting element (41) and a second electrical connecting element (42), the piezoelectric element (20) being carried by the support (10), and each of the first and second electrical connecting elements being electrically connected, respectively, to a first zone and a second zone, distinct from the first zone, of the piezoelectric element (20), the piezoelectric element (20) comprising a lower face (21) facing the support (10), and an upper face (22), opposite the lower face (21), **characterised in that** it comprises:
• a bonding of a piezoelectric block (23) on the support (10), so as to place the lower face of the piezoelectric block (23) facing the support (10);
• after the bonding and before thethinning, a coating of the piezoelectric block (23) with a polymer material layer, and
• a thinning of the piezoelectric block (23) from its upper face opposite its lower face (21), so as to obtain the piezoelectric element (20) with a dimension of predefined thickness, the upper face (22) of the piezoelectric element (20) being left fully exposed or only being left covered by the second electrical connecting element (42), the second electrical connecting element (42) fully covering the upper face (22) of the piezoelectric element (20),
• a thinning of the polymer material layer together with the thinning of the piezoelectric block (23), so as to obtain a cord (50) surrounding the piezoelectric element (20), and flush with the upper face (22) of the piezoelectric element (20), at least one part of the second electrical connecting element (42) being disposed on the cord (50), and the cord (50) covering at least one part of the first electrical connecting element (41), such that the cord (50) isolates the first electrical connecting element (41) and the second electrical connecting element (42).

12. Method according to the preceding claim, comprising, before the thinning, a formation of the support (10) on a substrate (70), and, after the thinning, a dismounting of the support (10) relative to the substrate (70).

13. Method according to the preceding claim, wherein the bonding is configured to put the first electrical connecting element (41) and the second electrical connecting element (42) in contact, with, respectively the first zone and the second zone, the first zone and the second zone being located on the lower face (21) of the piezoelectric element (20).

14. Method according to the preceding claim, comprising a supply of the piezoelectric block (23) which comprises an electrode (31) on its lower face (21), a division of the electrode into a first part and a second part, which are electrically isolated from one another, the first part and the second part forming, respectively, the first zone and the second zone.
